# EUROPÄISCHE PATENTSCHRIFT

(11) **EP 0 982 611 B1**
(45) Veröffentlichungstag und Bekanntmachung des Hinweises auf die Patenterteilung: **09.02.2005**
(21) Anmeldenummer: 99112963.6
(22) Anmeldetag: 05.07.1999
(51) Int. Cl.: G02B 6/42, H05K 5/02

(54) **Gehäuse**
Housing
Boîtier

(30) Priorität: 04.08.1998 DE 29813967 U
(43) Veröffentlichungstag der Anmeldung: 01.03.2000
(73) Patentinhaber: SICK AG, 79183 Waldkirch (DE)
(72) Erfinder: Dreher, Hubertus, 79215 Elzach (DE); Keglowich, Friedrich, 79276 Reute (DE)
(74) Vertreter: Manitz, Finsterwald & Partner

(56) Entgegenhaltungen:
- EP-A- 0 724 915
- EP-A- 0 783 088
- US-A- 4 233 493
- US-A- 5 392 197

## Beschreibung

Die vorliegende Erfindung betrifft ein Gehäuse einer optoelektronischen Schaltung. Weiterhin ist die Erfindung auf eine optoelektronische Vorrichtung mit einem entsprechenden Gehäuse gerichtet.

Gehäuse dieser Art, die beispielsweise optoelektronische Sensoren enthalten, werden üblicherweise zunächst oberflächenbehandelt, beispielsweise chromatiert oder eloxiert, und anschließend lackiert. Diese relativ aufwändigen Verfahrensschritte sind erforderlich, um die gewünschte Chemikalienbeständigkeit zu gewährleisten.

Aus der EP 0 783 088 ist eine rohrförmige Hülle zur Umhüllung von Kabeln oder Leitungen bekannt, deren äußerste Schicht aus hochtemperaturbeständigen Fluorpolymeren besteht. Diese Schicht ist als mikroporöse Schicht ausgebildet, so dass sie wie ein Filter wirkt, und Spritzwasser und sonstige Verschmutzungen nicht in den Innenbereich der Hülle eindringen können, die Umgebungsluft aber eindringen kann.

Aufgabe der Erfindung ist es, ein Gehäuse der eingangs genannten Art anzugeben, bei der die genannte aufwendige, zweistufige Oberflächenbehandlung nicht erforderlich ist, wobei die notwendige Chemikalienbeständigkeit trotzdem erhalten bleibt.

Diese Aufgabe wird erfindungsgemäß dadurch gelöst, dass die Außenfläche des Gehäuses wenigstens bereichsweise mit einer Antihaftbeschichtung versehen ist.

Durch die erfindungsgemäß verwendete Antihaftbeschichtung wird ein sehr guter Oberflächenschutz des Gehäusematerials und gleichzeitig eine sehr gute Chemikalienbeständigkeit erzielt. Durch die Antihaftbeschichtung wird erreicht, dass die Haftung an der Außenseite des Gehäuses, beispielsweise für Schmutz, reduziert wird, so daß u. a. der Nährboden für Bakterien verringert wird und gleichzeitig der Reinigungszyklus eines Gerätes mit einem erfindungsgemäßen Gehäuse verkürzt werden kann.

Auch Schweißfunken, die beispielsweise am Einsatzort des Gehäuses auftreten können, bleiben durch die Antihaftbeschichtung nicht an der Außenseite des Gehäuses hängen, so daß hier keine Einbrennungen auftreten können.

Vorteilhaft ist im wesentlichen die gesamte Außenfläche (mit Ausnahme der optischen Öffnung) des Gehäuses mit der Antihaftbeschichtung versehen. Dadurch wird erreicht, daß die gesamte Angriffsfläche für Schmutz, Bakterien, Chemikalien, Schweißfunken und dergleichen minimiert und im Optimalfall auf Null reduziert wird. Die durch die Haftung von z. B. Schmutz auftretenden oben genannten Probleme können somit praktisch vollständig eliminiert werden.

Nach einer vorteilhaften Ausführungsform der Erfindung besteht die Antihaftbeschichtung aus Polytetrafluorethylen (PTFE). Durch den Einsatz von PTFE werden zum einen sehr gute Antihafteigenschaften erreicht und ist zum anderen der Einsatz auch in der Lebensmittelindustrie möglich.

Nach einer weiteren bevorzugten Ausführungsform der Erfindung ist auch die Innenfläche des Gehäuses wenigstens bereichsweise mit einer Antihaftbeschichtung versehen. Diese kann bevorzugt wiederum aus PTFE bestehen. Die Beschichtung auch auf der Innenfläche des Gehäuses ist insbesondere bei nicht vollständig geschlossenen Gehäusen zweckmäßig. In diesem Fall gelten die für die Außenfläche des Gehäuses angegebenen Vorteile auch für dessen Innenfläche.

Das Gehäuse besteht bevorzugt aus Metall, insbesondere aus Aluminium, Zink, Messing oder dergleichen, und kann beispielsweise im Druckgußverfahren hergestellt sein. Grundsätzlich ist jedoch jedes beschichtbare Material, auch beispielsweise Kunststoff, geeignet, um als Grundlage für ein erfindungsgemäßes Gehäuse zu dienen.

Vorteilhaft kann die Antihaftbeschichtung eingefärbt, beispielsweise mit Farbpigmenten versetzt oder mit Lacken oder anderen Farben vermischt sein. Auf diese Weise kann in einem Arbeitsgang die gewünschte Gehäusefarbe erreicht werden.

Eine erfindungsgemäße optoelektronische Vorrichtung mit einem Gehäuse mit Antihaftbeschichtung kann beispielsweise als optoelektronische Sensoreinrichtung ausgebildet sein. Die optoelektronische Vorrichtung kann beispielsweise Licht aussendende oder empfangende Elemente enthalten und beispielsweise zur Abtastung eines Schutzbereichs, Bildung eines Lichtgitters, Abtastung von Gegenständen, wie beispielsweise Strichcodes, oder dergleichen ausgebildet sein.

Die erfindungsgemäße Verwendung einer Antihaftbeschichtung, insbesondere von PTFE, zur Beschichtung eines Gehäuses, insbesondere eines Gehäuses zur Aufnahme einer optoelektronischen Vorrichtung, ergibt somit sowohl wirtschaftliche als auch funktionelle Vorteile, die mit üblichen Beschichtungsverfahren nicht bzw. nur mit höherem wirtschaftlichen Aufwand erreicht werden können.

## Patentansprüche

1. Gehäuse einer optoelektronischen Schaltung,
**dadurch gekennzeichnet,**
**dass** die Außenfläche des Gehäuses wenigstens bereichsweise mit einer Antihaftbeschichtung versehen ist.

2. Gehäuse nach Anspruch 1,
**dadurch gekennzeichnet,**
**dass** im Wesentlichen die gesamte Außenfläche des Gehäuses mit der Antihaftbeschichtung versehen ist.

3. Gehäuse nach Anspruch 1 oder 2,
**dadurch gekennzeichnet,**
**dass** die Antihaftbeschichtung aus Polytetrafluorethylen (PTFE) besteht.

4. Gehäuse nach einem der vorhergehenden Ansprüche,
**dadurch gekennzeichnet,**
**dass** die Innenfläche des Gehäuses wenigstens bereichsweise mit einer Antihaftbeschichtung, insbesondere aus Polytetrafluorethylen (PTFE), versehen ist.

5. Gehäuse nach einem der vorhergehenden Ansprüche,
**dadurch gekennzeichnet,**
**dass** das Gehäuse aus Metall, insbesondere aus Aluminium, Zink, oder Messing besteht.

6. Gehäuse nach einem der vorhergehenden Ansprüche,
**dadurch gekennzeichnet,**
**dass** die optoelektronische Schaltung zumindest einen optischen Sensor umfasst.

7. Gehäuse nach einem der vorhergehenden Ansprüche,
**dadurch gekennzeichnet,**
**dass** die Antihaftbeschichtung eingefärbt ist.

8. Gehäuse nach einem der vorhergehenden Ansprüche,
**dadurch gekennzeichnet,**
**dass** eine durchsichtige oder durchscheinende optische Öffnung vorgesehen ist, die keine Antihaftbeschichtung aufweist.

9. Optoelektronische Vorrichtung mit einem Gehäuse nach einem der vorhergehenden Ansprüche.

## Claims

1. A housing of an optoelectronic circuit,
**characterized in that**
the outer surface of the housing is provided at least regionally with a non-stick coating.

2. A housing in accordance with claim 1, **characterized in that** substantially the whole outer surface of the housing is provided with the non-stick coating.

3. A housing in accordance with claim 1 or claim 2, **characterized in that** the non-stick coating consists of polytetrafluoroethylene (PTFE).

4. A housing in accordance with any one of the preceding claims, **characterized in that** the inner surface of the housing is provided at least regionally with a non-stick coating, in particular made of polytetrafluoroethylene (PTFE).

5. A housing in accordance with any one of the preceding claims, **characterized in that** the housing consists of metal, in particular of aluminum, zinc or brass.

6. A housing in accordance with any one of the preceding claims, **characterized in that** the optoelectronic circuit includes at least one optical sensor.

7. A housing in accordance with any one of the preceding claims, **characterized in that** the non-stick coating is colored.

8. A housing in accordance with any one of the preceding claims, **characterized in that** a transparent or translucent optical aperture is provided which does not have any non-stick coating.

9. An optoelectronic apparatus having a housing in accordance with any one of the preceding claims.

## Revendications

1. Boîtier d'un montage optoélectronique
**caractérisé en ce que** la surface extérieure du boîtier est pourvue, au moins par zones, d'un revêtement anti-adhérence.

2. Boîtier selon la revendication 1,
**caractérisé en ce que** l'ensemble de la surface extérieure du boîtier est pour l'essentiel pourvu du revêtement anti-adhérence.

3. Boîtier selon la revendication 1 ou 2,
**caractérisé en ce que** le revêtement anti-adhérence est en polytétrafluoroéthylène (PTFE).

4. Boîtier selon l'une quelconque des revendications précédentes,
**caractérisé en ce que** la surface intérieure du boîtier est munie d'un revêtement anti-adhérence, au moins par zones, qui est notamment en polytétrafluoroéthylène (PTFE).

5. Boîtier selon l'une quelconque des revendications précédentes,
**caractérisé en ce que** le boîtier est en métal, notamment en aluminium, zinc ou laiton.

6. Boîtier selon l'une quelconque des revendications précédentes,
**caractérisé en ce que** le montage optoélectronique comporte au moins un capteur optique.

7. Boîtier selon l'une quelconque des revendications précédentes,
**caractérisé en ce que** le revêtement anti-adhérence est coloré.

8. Boîtier selon l'une quelconque des revendications précédentes,
**caractérisé en ce qu'**il est prévu une ouverture optique transparente ou translucide, qui ne comporte pas de revêtement anti-adhérence.

9. Dispositif optoélectronique comportant un boîtier selon l'une quelconque des revendications précédentes.
